(19) Europäisches Patentamt
European Patent Office
Office européen des brevets

(11) **EP 3 997 445 B1**

(12) **EUROPEAN PATENT SPECIFICATION**

(45) Date of publication and mention
of the grant of the patent:
**11.03.2026 Bulletin 2026/11**

(21) Application number: **19708633.3**

(22) Date of filing: **21.02.2019**

(51) International Patent Classification (IPC):
*G01N 21/73* (2006.01)     *G01L 21/30* (2006.01)
*C23C 14/34* (2006.01)     *G01L 27/00* (2006.01)
*H01J 37/32* (2006.01)     *G01N 21/84* (2006.01)

(52) Cooperative Patent Classification (CPC):
**G01N 21/73; C23C 14/34; G01L 21/30;
G01L 27/002; H01J 37/32972; H01J 37/32981;**
G01N 2021/8411

(86) International application number:
**PCT/GB2019/050484**

(87) International publication number:
**WO 2019/162681 (29.08.2019 Gazette 2019/35)**

(54) **PLASMA MONITORING METHOD AND APPARATUS**

PLASMAÜBERWACHUNGSVERFAHREN UND -VORRICHTUNG

PROCEDE ET DISPOSITIF DE SURVEILLANCE DU PLASMA

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.02.2018 GB 201802848**

(43) Date of publication of application:
**18.05.2022 Bulletin 2022/20**

(73) Proprietor: **Gencoa Ltd
Liverpool Merseyside L24 8RN (GB)**

(72) Inventors:
• **BRINDLEY, Joseph
Liverpool Merseyside L24 8RN (GB)**
• **BELLIDO-GONZALEZ, Victor
Liverpool Merseyside L24 8RN (GB)**

(74) Representative: **Hutchinson, Thomas Owen
Hutchinson IP Ltd
57 Hoghton Street
Southport, Merseyside PR9 0PG (GB)**

(56) References cited:
**EP-A1- 2 128 301**

**Description**

This invention relates to a method of measuring the actual concentration or partial pressure of a target gas species in a partially-evacuated atmosphere comprising a plurality of different gas species, and to an apparatus for carrying out the method.

Many industrial processes require, or are carried out under, partial vacuum conditions. Examples of industrial processes that require, or which are carried out under, partial vacuum conditions include, but are not limited to: vacuum coating processes (such as sputtering, magnetron sputtering, chemical vapour deposition, physical vapour deposition); clean room processes (such as semiconductor fabrication); and food/pharmaceutical manufacturing processes.

This invention is particularly relevant to (but is not limited to) industrial coating processes, which use plasmas or evaporated materials, which sputter, or otherwise deposit, material from a target onto a substrate to be coated. In these cases, the plasma, arc or vaporisation process often involves ionising a gas, and therefore the nature of the gas affects the nature of the plasma, arc etc., and thereby the nature and quality of the resultant coating. As such, the quality of the resultant coating can be largely dependent on the gas within the system at the time the plasma is generated and used.

Other sensitive industrial processes, such as electronics fabrication, need to be carried out in clean, controlled atmospheres. Evacuated environments, or environments where the ambient gas is carefully controlled, are therefore sometimes used for such processes.

It will be readily apparent to the skilled reader that where an environment or atmosphere needs to be controlled, that there is often a need to monitor the environment or atmosphere, for example, for process control and/or quality assurance purposes.

There are many ways in which partially evacuated environments can be monitored, for example by using pressure gauges to measure pressure, and other sensors to measure the concentration of target gasses or species within the atmosphere.

Remote optical emission spectroscopy is an example of a gas sensing technique, which can be used to detect and monitor the concentrations of gases present in an environment. The technique involves the generation of a plasma within a measuring system that is connected to the environment to be monitored.

The prior art patent application publication EP 2 128 301 A1 describes a carburizing apparatus that performs a vacuum carburizing treatment with respect to an object. The carburizing apparatus includes: a carburizing furnace that contains the object; a gas supply apparatus that supplies a carburizing gas to the carburizing furnace; a light emitting device that emits light by using an in-furnace gas inside of the carburizing furnace which is supplied with the carburizing gas; a light-receiving device that receives light emitted from the light emitting device; and a processing device that calculates the composition of the in-furnace gas based on the light receiving result of the light receiving device. A structure may be employed, in which the light emitting device generates plasma in a space which includes the in-furnace gas.

Embodiments of the invention shall be described, by way of example, with reference to the accompanying drawings in which:

Figure 1 is a schematic diagram of a known monitoring apparatus;
Figure 2 is a plot of plasma emission intensity versus time for a known monitoring apparatus;
Figure 3 is first a plot of plasma emission intensity versus time for according to an embodiment of the method and/or apparatus of the invention;
Figure 4 is a second plot of plasma emission intensity versus time for according to an embodiment of the method and/or apparatus of the invention; and
Figure 5 is a schematic diagram of a monitoring apparatus in accordance with an embodiment of the invention.

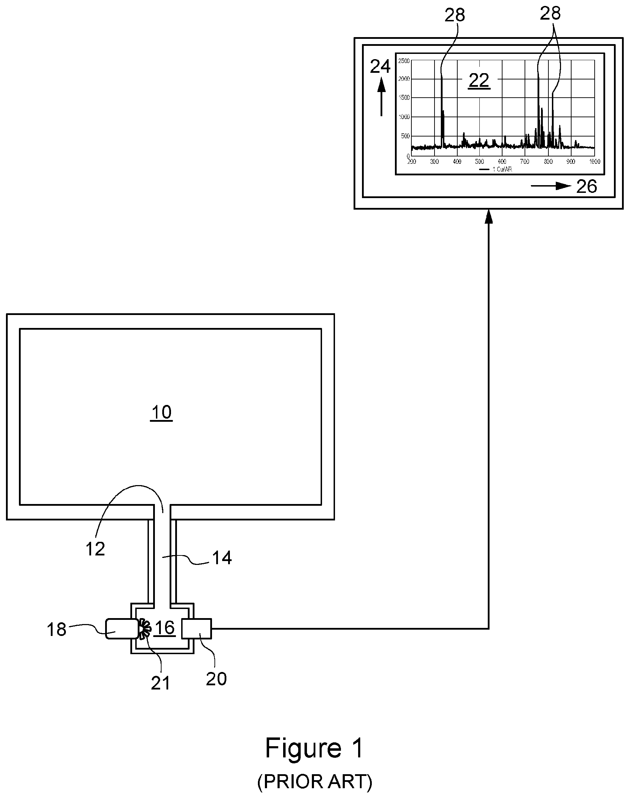

A known optical emission spectroscopy apparatus is illustrated, schematically, in Figure 1 of the drawings. With reference to Figure 1, there is shown a process chamber 10, in which a vacuum process is carried out. A port 12 of the process chamber 10 leads, via a conduit 14, to a sample chamber 16, which contains a plasma source 18 and an optical spectrometer 20. Because the process chamber 10 and the sample chamber 16 are interconnected via the conduit 14, changes in the atmosphere within the process chamber 10 are replicated in the sample chamber 16, albeit with a slight lag due to the time it takes for diffusion to allow the atmospheres within the respective chambers 10, 16 to equalise.

The gaseous species present in the environment will diffuse into the sample chamber 16 and become excited by the plasma 21. This will cause the gases to emit light which can then be analysed by the spectrometer 20.

Typically, a miniature spectrometer 20 is used to analyse the light emissions of the plasma source 18, and from this, a graph 22 of relative intensity 24, versus wavelength 26 can be obtained. The graph 22 has a set of peaks 28, each of which occur at specific, narrow wavelength bands, which are characteristic of the light emissions from certain species.

The height of the peaks is indicative of the relative concentrations of each of the species, and so it is possible to obtain an indication of the concentration of each monitored species at a certain point in time. By running the plasma source 18 and the spectrometer 20 continuously (or at intervals), it is possible to observe the changes in the time-domain.

A limitation of this known approach is that the readings produced are qualitative rather than quantitative. As such, accurate partial pressure measurements are not obtainable directly by using this known method.

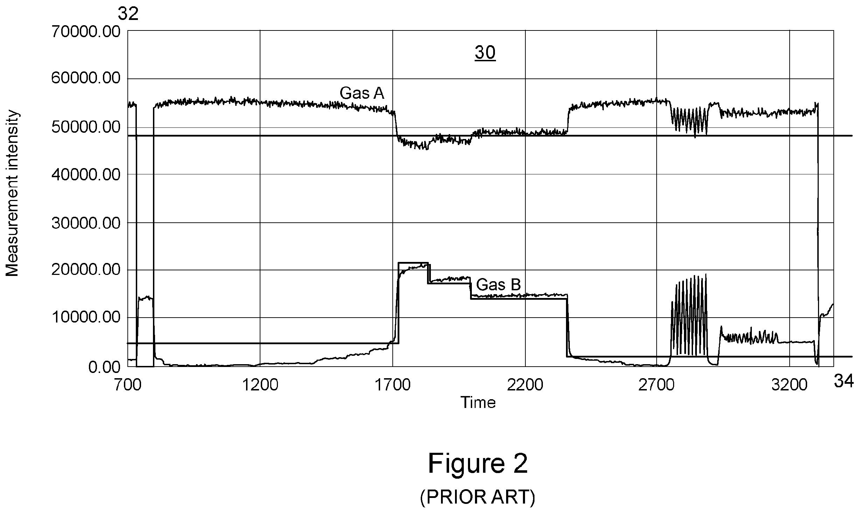

For example, and referring to Figure 2 of the drawings, which is a plot 30 of the relative concentration 32 of two species (argon and oxygen, in this example) over time 34.

As can be seen, in the case where there are two species present (e.g. gas "A" and gas "B") in the atmosphere, an increase in the concentration of gas A will result in a reduction of the measured concentration reading of gas B. This is due to a lowered statistical probability of an electron colliding with (and exciting) gas B as well as, in some cases, the lowering of the plasma's electron temperature by the increase in the concentration of gas A.

Another way to think of this is that the measured intensities are not absolute (i.e. in proportion to the concentration of a particular species), but rather somewhat relative to one another. Thus, if initially, the total of all of the measured intensities is, say unity, and if the intensity at one wavelength increases, the total of all of the measured intensities may now increase to, say, 1.1. Because the overall, total recorded intensity has now increased, this then results in the relative intensities at other wavelengths decreasing, as a proportion of the total measured intensity - even if the absolute intensity at the other wavelengths has not, in fact, actually changed.

Thus, whilst in the case of a single-species atmosphere, it may be possible to obtain reasonably accurate measurement of gas concentration readings over time, where more than one species is present, the interactions between the species cause the reading to become skewed or biased, with the result that the direct relationship between measured intensity and concentration is destroyed.

This phenomenon is believed to occur because the plasma has free electrons, which cause the light emission. The more of one gas that there is, the less free electrons the other gasses have, and so the ability for the other gasses to emit light will be affected. Depending on what the gases are, and how they interact, the level of suppression will be stronger/weaker at differing relative concentrations of the species.

The present invention, defined by the appended independent claims, aims to provide a solution to this problem in the form of a method that corrects for gas interaction effects, thereby providing a quantitative, rather than a relative or qualitative reading of gas concentration when using a remote plasma emission monitoring technique.

The invention is defined by the appended independent claims. Preferred or optional features of the invention are set forth in the appended dependent claims.

Whilst the mechanisms of gas interactions and its effects on light emission are complex, it has surprisingly been found that there is a generally proportional relationship between an increase in the concentration of one gas and the consequential decrease in the light emissions of other gasses in the partially-evacuated atmosphere. As such, is has surprisingly, but nevertheless usefully, been found that it is possible to formulate a relationship between gases that can correct for their interaction.

Generally, the corrected gas concentration reading (light emission value) for a gaseous species, $G1_c$, is a function of the uncorrected reading for the gaseous species, $G1$, and the other gases present in the vacuum, $G2, G3, ... Gn$. This can be expressed in the general form as $G1_c = f_n(G1, G2, ... Gn)$.

More explicitly, in the case of a binary gas interaction, the relationship can take the form of:

$$G1_c = G1 + k_{12}G1G2$$

$$G2_c = G2 + k_{21}G2G1$$

where $k_{12}$ and $k_{21}$ are coefficients that define the relationship between the gases, or in a tertiary gas interaction:

$$G1_c = G1 + k_{12}G2 + k_{13}G3$$

$$G2_c = G2 + k_{21}G1 + k_{23}G3$$

$$G3_c = G3 + k_{31}G1 + k_{32}G2$$

Thus, the function of the invention suitably takes the form of a linear coefficient-type equation where the corrected gas concentration for a given species is the measured concentration for that species, plus a coefficient multiplied by the product of the measured concentrations of the other species.

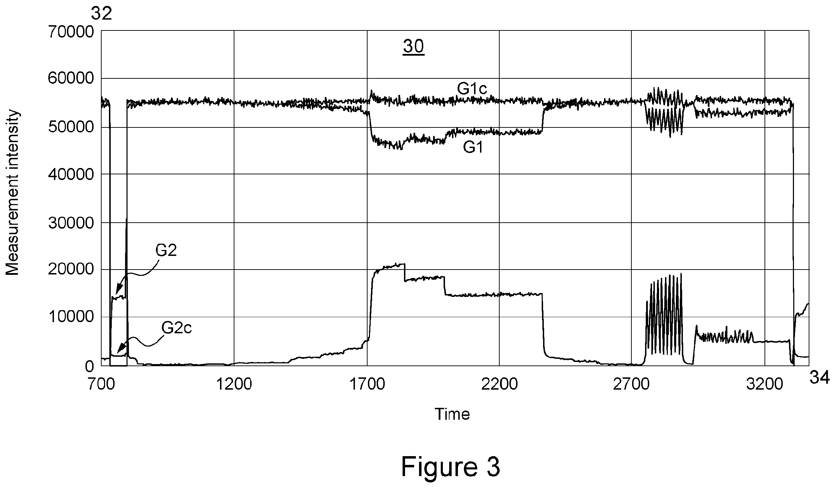

For the example of a binary gas system the effect of the gas reading correction can be seen in Figure 3 where the interaction between the gas readings has been eliminated.

Where there are more than two species present in the (partially-evacuated) atmosphere, it is convenient to use a coefficient matrix of the following general form, in other words, the relationship can also be expressed for n number of gases by the following expression:

$$
\begin{bmatrix} G1_c \\ G2_c \\ \vdots \\ Gn_c \end{bmatrix} = \begin{bmatrix} 1 & k_{12}G1 & \cdots & k_{1n}G1 \\ k_{21}G2 & 1 & \cdots & k_{2n}G2 \\ \vdots & \vdots & \ddots & \vdots \\ k_{n1}Gn & k_{n2}Gn & \cdots & 1 \end{bmatrix} \begin{bmatrix} G1 \\ G2 \\ \vdots \\ Gn \end{bmatrix}
$$

The coefficients $k_{nn}$ can be determined by using a calibration procedure whereby a gas is introduced into the environment and the change in reading of the systems other gases is recorded.

According to a yet further aspect of the invention, there is provided a method for determining the correction coefficients for use in a method of measuring the actual concentrations of each of the gas species as described herein, the calibration method comprising the steps of: measuring the relative intensities of the peaks of a plasma emission spectrum for a set of process gases at fixed, arbitrary initial concentrations; adjusting the concentration of each one of the gas species in turn, whilst maintaining the concentrations of the other gas species at the said, initial concentrations; for each permutation, measuring the changes in the measured relative intensities of the peaks of the plasma emission spectrum; and determining the coefficients by solving a set of simultaneous equations.

By way of example, consider the following two gas system ($G1$, $G2$).

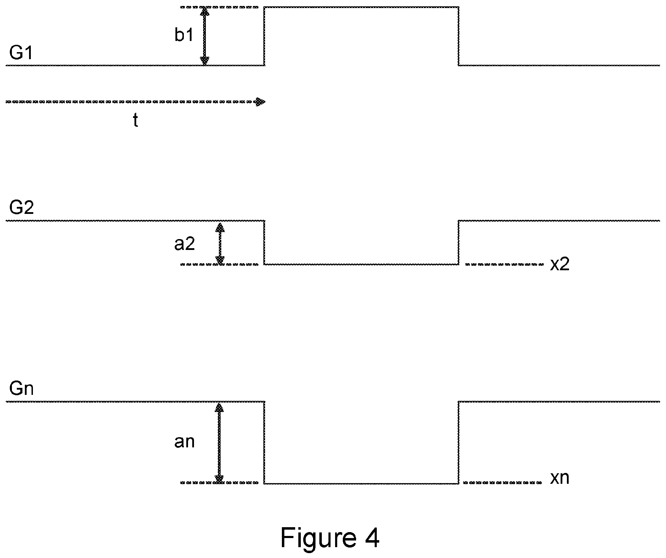

With reference to Figure 4, at time $t1$ the gas $G1$ is introduced into the environment. The coefficient $k_{21}$ can be determined from the following relation, using the values of the gas readings at time t1:

$$
k_{21} = \frac{G2_c - G2}{G2G1}
$$

Similarly, $k_{12}$ can be determined by using the following relation and the values of the gas readings at time t2:

$$
k_{21} = \frac{G1_c - G1}{G1G2}
$$

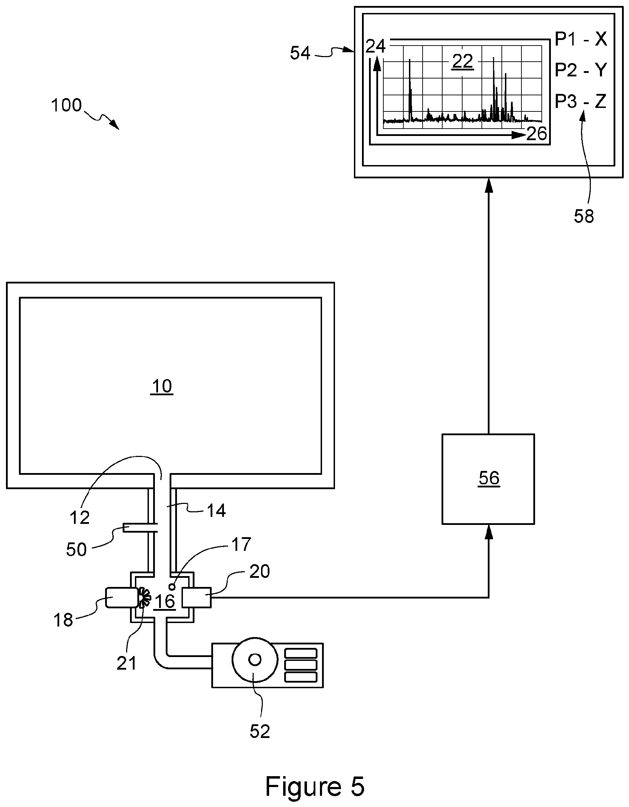

For $n$ number of gases this method can be used, however for each $i$ in $k_{in}$ (where $i = 1 \ldots n$) there must be $n$ - 1 sets of gas injection cases. This is illustrated in Figure 5 for a three-gas system, G1, G2, G3. This results in a set of simultaneous equations to be solved for each $k_{in}$. Shown below is the example for $k_{1n}$ with the case number denoted by $x$ in $Gi_x$.

$$
\begin{bmatrix} k_{12} \\ k_{13} \\ \vdots \\ k_{1n} \end{bmatrix} = \begin{bmatrix} 1 & \dfrac{G3_1}{G2_1} & \cdots & \dfrac{Gn_1}{G2_1} \\ \dfrac{G2_2}{G3_2} & 1 & \cdots & \dfrac{G3_2}{Gn_2} \\ \vdots & \vdots & \ddots & \vdots \\ \dfrac{G2_{n-1}}{Gn_{n-1}} & \dfrac{G3_{n-1}}{Gn_{n-1}} & \cdots & 1 \end{bmatrix}^{-1} \begin{bmatrix} \dfrac{G1_{c1}}{G1_1 G2_1} - \dfrac{1}{G2_1} \\ \dfrac{G1_{c2}}{G1_2 G3_2} - \dfrac{1}{G3_2} \\ \dfrac{G1_{cn-1}}{G1_{n-1}Gn_{n-1}} - \dfrac{1}{Gn_{1n-1}} \end{bmatrix}
$$

The foregoing results in a correction whereby the corrected intensity value is now proportional to the concentration of the target species. Thus, by using this proportional relationship between the corrected intensity value and the concentration of the target species, it is possible to derive numerical partial pressure values of gases (1 through to $n$).

In one case, this can be achieved by applying a yet further coefficient to the corrected intensity value. The partial pressure of gas n, $Pn_p$, can thus be determined by applying a coefficient to the corrected gas readings i.e. $Pn_p = kn_p Gn_c$. The value of $kn_p$ will be dependent on the gas species being measured and the units of partial pressure to be used.

In an alternative method, the partial pressures can be determined by dividing the total pressure of the gas system pro rata according to the relative corrected concentration values. This technique requires a pressure sensor to measure the total gas pressure, but avoids introducing possible errors by the application of a yet further experimentally-determined coefficient. In other words, the partial pressure can be based on a fraction of the total pressure reading. If a measurement of the total pressure ($P_{tot}$) can be obtained, either from the remote plasma source itself or an external gauge, then the partial pressure of each gas being measured can be obtained using the following relation:

$$Pn_p = kn_p P_{tot} \frac{Gn_c}{\sum_{i=1}^{n} Gi_c}$$

where $kn_p$ is a calibration parameter for each individual gas partial pressure measurement.

In a method in accordance with the invention, determining partial pressures for measured gases is found by combining plasma emission monitoring and total pressure measurement.

In the method described in greater detail below, it is assumed that the emission intensity for a particular species is dependent on its concentration. Therefore, if emission intensities are measured, at characteristic wavelengths, for each species, the measured intensities are proportional to the concentration, and hence the partial pressure, of each species in the atmosphere. The total pressure can be measured using any suitable pressure gauge, and so:

$$P_t = p_1 + p_2 + p_3 \propto \frac{E_1}{E_1 + E_2 + E_3} + \frac{E_2}{E_1 + E_2 + E_3} + \frac{E_3}{E_1 + E_2 + E_3}$$

Where:

$P_t$ is the total measured pressure of the atmosphere;
$p_1$ is the partial pressure of species 1;
$p_2$ is the partial pressure of species 2;
$p_3$ is the partial pressure of species 3;
$E_1$ is the measured emission intensity for species 1, at its characteristic wavelength;
$E_2$ is the measured emission intensity for species 2, at its characteristic wavelength; and
$E_3$ is the measured emission intensity for species 3, at its characteristic wavelength.

Therefore, if the total pressure of the system ($P_t$) can be measured in conjunction with the emission intensities ($E_1$, $E_2$, $E_3$) for each species at their respective characteristic wavelengths, then it is possible to calculate the partial pressures ($p_2$, $p_2$, $p_3$) of each of species 1, 2, 3 in the system.

For the generalised case of a measured gas optical emission, $E_i$, that is part of the set $\{E_1, E_2, E_3 ... E_n\}$, then the ratio of each gas emission, $Er_i$, to the total emission-is given by the equation:

$$Er_i = \frac{E_i}{\sum_n^{i=1} E_i}$$

Different atoms or molecules do not emit light with equal intensity when present at the same partial pressure. Therefore, an individual calibration coefficient, $K_{r_i}$, is ideally applied to the individual emission readings in order convert the ratio of light emission to that of the ratio of partial pressures, $Gr$. Hence:

$$Gr_i = \frac{K_{r_i} E_i}{\sum_n^{i=1} K_{r_i} E_i}$$

Interaction of gases within a gas mixture leads to suppression effects on the emissions. This results in the absolute values of the gas emission intensities not being equivalent to the gas partial pressures, as previously discussed. However, the *ratio* of emission intensities (after appropriate correction factors have been applied) is equivalent the ratio of partial pressures. Therefore, the partial pressures of the measured gases, $G_p$, can then be obtained by multiplying the individual gas ratios by the total pressure, $P_t$:

$$G_{p_i} = Gr_i P_t$$

The total pressure can be obtained via a secondary pressure gauge, such as a capacitance manometer, penning gauge or Pirani gauge. Alternatively, the pressure reading can be derived from the voltage and current readings of the sensors own plasma generated using the inverted magnetron pressure measurement method.

In order to obtain an accurate partial pressure measurement for individual gases, the total pressure measurement must be absolute and accurate. Most pressure measurement devices are gas dependent, whereby the gas mixture of the vacuum has an effect on the total pressure measurement. This is due to thermal effects (as in the case of a Pirani gauge), or due to different ionisation rates (as in the case with hot or cold cathode gauges). A capacitance manometer is an exception insofar as it measures true pressure, however it tends to be more expensive, requires valving during venting and operates over a limited pressure range.

Gas correction factors for individual gas species are widely used in order to correct for gas dependency on total pressure measurement. For the example of an ionisation-based gauge, air has a correction factor of 1.00 and Ar has a factor of 1.29. Since the exact ratio of gases are known by the sensor then a total gas correction factor that is the weighted arithmetic mean of the individual gas correction factors can be applied to correct the total pressure reading. In this way a gas dependent pressure gauge can be automatically and accurately corrected to the true pressure reading. This can be expressed by the following where $P_{tc}$ is the corrected total pressure and $k_p$ is the individual gas species correction factor:

$$P_{tc} = P_t \left( \sum_{n}^{i=1} Gr_i k_{p_i} \right)$$

In certain embodiments of the invention, a processor is provided, which computes any one or more of the corrected intensity values; and the partial pressures. The processor is suitably provided with a memory device, which can store the relevant and/or required coefficients for a particular, or general, processes. Accordingly, when equipped with such a processor and memory device, the invention is able to output corrected intensity values and/or actual partial pressures for each species - preferably in real-time. This amounts to a significant step forward in plasma monitoring systems, which hitherto have required a great deal of post-processing and/or interpretation to ascertain the concentrations and/or partial pressures in a given partially-evacuated atmosphere.

The invention can, therefore, effectively replace a conventional quadrupole mass spectrometer - the *de facto* industry-standard tool for determining the partial pressures of mixed process gases. Specifically, quadrupole mass spectrometers don't operate at absolute pressures exceeding about $10^{-2}$ Pa ($10^{-4}$ mbar) which means that in order to use the industry-standard tool, namely a quadrupole mass spectrometer, additional pumps and chambers are required to rarefy the gas sample to pressures below $10^{-2}$ Pa ($10^{-4}$ mbar) in order for the quadrupole mass spectrometer to operate. It will be appreciated that adding further layers of abstraction (i.e. artificially reduced pressure) between the actual atmosphere that requires testing and the atmosphere within the test chamber not only complicates the procedure, but also introduces errors and distortions in the readings obtained.

However, the invention merely requires a relatively simple plasma source and detector, which can work in pressures up to about 100 Pa (1 mbar). Thus, the need for differential pump systems is avoided, and so the invention can measure the target atmosphere directly. Further, the cost, complexity, operational insensitivity to transient conditions, and the part count of the plasma source-detector arrangement that the invention requires are significantly lower than an equivalent quadrupole mass spectrometer setup.

In other embodiments of the invention, the method and apparatus can be used to monitor the composition of an atmospheric pressure, or near-atmospheric pressure environment (e.g. 100 kPa (1 bar) to 10 kPa (0.1 bar). In this case, the invention comprises a conduit interconnecting the atmosphere to be monitored and a test chamber. The test chamber is suitably evacuated (to about 100 Pa (1 mbar), or between about 100 Pa (1 mbar) and 10 Pa (0.1 mbar)) using a vacuum pump and the conduit suitably comprises a restricted orifice, which enables a pressure differential to be maintained between the atmosphere to be tested and the atmosphere within the test chamber. The restricted orifice is preferably adjustable, for example, comprising a needle valve, so that the pressure differential can be adjusted.

It will be appreciated from the foregoing, that the pressure within the test chamber can be as high as about 100 Pa (1 mbar), which means that the vacuum pump can be of a relative simple and/or inexpensive type, colloquiality known as a "roughing pump". Thus, the invention avoids having to have expensive pumps, such as multi-stage vacuum pumping system, a turbomolecular pump and/or a diffusion pump for example; but can use instead a relatively simple pump, such as: a rotary vane pump; a rotary piston pump; a diaphragm pump; a scroll pump; a screw pump; a claw pump; and/or a Roots pump.

An embodiment of an apparatus 100 for carrying out the invention is shown in Figure 5 of the drawings, which is similar to the known monitoring system shown in Figure 1. In this embodiment, the process chamber 10 contains a relatively high-pressure atmosphere, at say 0.1 bar to 1 bar, which needs to be monitored. In this case, the process chamber 10 is connected to a sample chamber 16 by a conduit 14, which as a needle valve 50 in it to as to maintain a pressure differential between the process chamber 10 and the sample chamber 16.

A vacuum pump, such as a rotary vane pump, 52 evacuates the test chamber 16 to about 1mbar, which is sufficient to enable the plasma source 18 to generate a plasma 21 which is "observed" by the optical spectrometer 20. A total pressure gauge 17 configured to measure the total pressure (Pt) in the sample chamber is also provided, for certain embodiments of the invention.

Because the process chamber 10 and the sample chamber 16 are interconnected via the conduit 14, changes in the atmosphere within the process chamber 10 are substantially replicated, albeit that the atmosphere in the sample chamber 16 is more rarefied.

The spectrometer 20 is typically a miniature spectrometer 20, and it analyses the light emissions of the plasma 21, and from this, can output, on a display screen 54, a graph 22 of relative intensity 24, versus wavelength 26.

The apparatus 100 further comprises a processor 56, which performs the aforedescribed method of the invention to obtain partial pressure values 58 for each species in the atmosphere within the process chamber 10, and which outputs or displays those partial pressure values 58 on the display 54.

Thus, the invention provides manifold advantages over the current industry-standard gas monitoring technique. Other benefits and advantages will be readily apparent to the skilled reader.

## Claims

1. A method of measuring the actual concentration or partial pressure of a target gas species in a partially-evacuated atmosphere (10) comprising a plurality of different gas species, such as species 1 to 3, the method comprising the steps of:

   a. generating a plasma (21) in the partially-evacuated atmosphere (10) or in a sample of the partially-evacuated atmosphere (10);
   b. measuring the intensity of light emissions from the plasma (21) at wavelengths that correspond to characteristic emission wavelengths of each of the gas species in the partially-evacuated atmosphere (10);
   c. measuring the total pressure of the partially-evacuated atmosphere (10); and
   d. calculating the actual concentrations or partial pressures of the target gas species using an equation of the form:

   $$P_t = p_1 + p_2 + p_3 \propto \frac{E_1}{E_1 + E_2 + E_3} + \frac{E_2}{E_1 + E_2 + E_3} + \frac{E_3}{E_1 + E_2 + E_3}$$

   where:

   $P_t$ is the total measured pressure of the atmosphere;
   $p_1$ is the partial pressure of species1;
   $p_2$ is the partial pressure of species 2;
   $p_3$ is the partial pressure of species 3;
   $E_1$ is the measured emission intensity for species 1, at its characteristic wavelength;
   $E_2$ is the measured emission intensity for species 2, at its characteristic wavelength; and
   $E_3$ is the measured emission intensity for species 3, at its characteristic wavelength,

   the method further comprising:
   applying a correction to the measured intensity corresponding to each or the target gas species to obtain a corrected intensity for each or that species, which corrected intensity is proportional to the actual concentration of each or the target gas species in the partially-evacuated atmosphere (10), wherein:

   the correction for each gas species is a separate function of the measured intensities for all of the species in the partially-evacuated atmosphere (10); or
   the correction is a function of the measured intensities of all of the species in the partially-evacuated atmosphere (10), respectively.

2. The method of claim 1, wherein the function or functions takes or take the form of linear coefficient-type equations where the corrected intensity for a given species is the measured concentration for that species, plus a coefficient multiplied by the product of the measured concentrations of the other species.

3. The method of claim 2, wherein the function comprises:

   a linear coefficient-type function of the general form: $Gn_c = Gn + k_{n1} G1 + k_{n2} G2 + \cdots + k_{n(n-1)} G(n-1)$, where $Gn_c$ is the corrected intensity value for gas n, where $k_{nx}$ is the coefficient relating gases n and x, and where Gx is the measured intensity value for gas x; or
   a linear coefficient-type function of the general form, which can be expressed in the general form:

$$\begin{bmatrix} G1_c \\ G2_c \\ \vdots \\ Gn_c \end{bmatrix} = \begin{bmatrix} 1 & k_{12}G1 & \cdots & k_{1n}G1 \\ k_{21}G2 & 1 & \cdots & k_{2n}G2 \\ \vdots & \vdots & \ddots & \vdots \\ k_{n1}Gn & k_{n2}Gn & \cdots & 1 \end{bmatrix} \begin{bmatrix} G1 \\ G2 \\ \vdots \\ Gn \end{bmatrix}$$

where $Gn_c$ is the corrected intensity value for each gas n, where $k_{nx}$ are the coefficients relating gases n and x, and where Gx is the measured intensity value for gas x.

**4.** The method of claim 3, wherein the coefficients $k_{nn}$ are determined by using a calibration procedure in which a gas is introduced into the environment and the change in reading of the systems other gases is recorded wherein the correction coefficients are determined by:

a. measuring the relative intensities of the peaks of the plasma emission spectrum for a set of process gases at initial concentrations;
b. adjusting the concentration of each one of the gas species in turn, whilst maintaining the concentrations of the other gas species at the said, initial concentrations;
c. for each permutation, measuring the changes in the measured relative intensities of the peaks of the plasma emission spectrum; and
d. determining the coefficients by solving a set of simultaneous equations.

**5.** The method of claim 4, for a binary gas system, wherein the simultaneous equations are:

$$k_{21} = \frac{G2_c - G2}{G2G1} \quad \text{-(1)}$$

and

$$k_{21} = \frac{G1_c - G1}{G1G2} \quad \text{-(2)}$$

**6.** The method of claim 4, for a gas system comprising $n$ gases, wherein the simultaneous equations are:

$$\begin{bmatrix} k_{12} \\ k_{13} \\ \vdots \\ k_{1n} \end{bmatrix} = \begin{bmatrix} 1 & \frac{G3_1}{G2_1} & \cdots & \frac{Gn_1}{G2_1} \\ \frac{G2_2}{G3_2} & 1 & \cdots & \frac{G3_2}{Gn_2} \\ \vdots & \vdots & \ddots & \vdots \\ \frac{G2_{n-1}}{Gn_{n-1}} & \frac{G3_{n-1}}{Gn_{n-1}} & \cdots & 1 \end{bmatrix}^{-1} \begin{bmatrix} \frac{G1_{c1}}{G1_1 G2_1} - \frac{1}{G2_1} \\ \frac{G1_{c2}}{G1_2 G3_2} - \frac{1}{G3_2} \\ \frac{G1_{cn-1}}{G1_{n-1} Gn_{n-1}} - \frac{1}{Gn_{1n-1}} \end{bmatrix}$$

**7.** The method of claim 4, 5 or 6, further comprising the step of incorporating a calibration coefficient to compensate for the fact that different atoms or molecules do not emit light with equal intensity when present at the same partial pressure, the calibration coefficient, $K_r$, being applied to the individual emission readings in order convert the ratio of light emission to that of the ratio of partial pressures, $Gr$, according to the formula: $Gr_i = \frac{K_{ri}E_i}{\sum_n^{i=1} K_{ri}E_i}$

**8.** The method of claim 7, wherein the partial pressure of a target gas, $G_p$ is obtained by multiplying the individual gas ratios by the total pressure, $P_t$, where $G_{pi} = Gr_i P_t$.

**9.** The method of any preceding claim, wherein the ratio of each gas emission to the total emission, $Er_i$, is given by the equation: $Er_i = \frac{E_i}{\sum_n^{i=1} E_i}$

**10.** The method of any preceding claim, further comprising the step of correcting the total pressure by using a gas correction factor for each target gas species, and by multiplying the measured total pressure by a weighted mean of the gas correction factors for each target species, the weighted mean being expressed by the formula: $P_{tc} = P_t(Gr_1 k_{p1}$

$+ Gr_2k_{p2} ... Gr_nk_{pn})$.

11. The method of any preceding claim, wherein the total pressure is obtained using a secondary pressure gauge (17) being any one or more of the group comprising: a capacitance manometer; a penning gauge; and a Pirani gauge - or by using the voltage and/or current measurements of the sensor's plasma generator.

12. The method of any preceding claim, further comprising the step of converting the corrected intensity values for each gas species into respective partial pressures for each gas species.

13. The method of claim 12, wherein the step of converting the corrected intensity values for each gas species into respective partial pressures for each gas species comprises multiplying each corrected intensity value by a conversion coefficient for each gas, the conversion coefficient relating each corrected intensity value to a corresponding partial pressure value.

14. The method of claim 12 or claim 13, wherein the step of converting the corrected intensity values for each gas species into respective partial pressures for each gas species comprises: measuring the total pressure of the partially-evacuated atmosphere (10) and dividing the total pressure of the partially-evacuated atmosphere (10) pro rata in accordance with each corrected intensity value to obtain a partial pressure value for each gas as a fraction of the overall pressure.

15. An apparatus (100) for carrying out the method of any preceding claim, the apparatus comprising:

a test chamber (16) in fluid communication with the partially-evacuated atmosphere (10) to be analysed, a plasma source (18) adapted to produce a plasma (21) within the test chamber (16); a light detector, such as a spectrometer (20), arranged to detect light emissions from the plasma (21); and a processor (56), the processor (56) being adapted, in use, to: obtain a spectrum of light intensity versus wavelength, and to determine the intensity of the light emissions from the plasma (21) at wavelengths corresponding to the characteristic emission wavelengths of each of the gas species in the partially-evacuated atmosphere (10), to calculate the partial pressures of the target gas species, and to apply a correction to the measured intensity corresponding to each or the target gas species to obtain a corrected intensity for each or that species, which corrected intensity is proportional to the actual concentration of each or the target gas species in the partially-evacuated atmosphere (10), wherein the correction for each gas species is a separate function of the measured intensities for all of the species in the partially-evacuated atmosphere (10); or the correction is a function of the measured intensities of all of the species in the partially-evacuated atmosphere (10), respectively, the apparatus further comprising:

a total pressure gauge (17), being any one or more of the group comprising: a capacitance manometer; a penning gauge; and a Pirani gauge, configured to measure the total pressure within the test chamber (16); and
a conduit (14) interconnecting the test chamber (16) and the partially-evacuated atmosphere (10) to be analysed; an adjustable restricted orifice, such as a needle valve (50), the adjustable restricted orifice associated with the conduit (14) which enables, in use, a pressure differential to be maintained between the partially-evacuated atmosphere (10) to be analysed and an atmosphere within the test chamber (16); and a vacuum pump (52) for evacuating the test chamber (16).

**Patentansprüche**

1. Verfahren zum Messen der tatsächlichen Konzentration oder des Partialdrucks einer Zielgasspezies in einer teilweise evakuierten Atmosphäre (10), die eine Vielzahl verschiedener Gasspezies, wie Spezies 1 bis 3, umfasst, wobei das Verfahren die folgenden Schritte umfasst:

a. Erzeugen eines Plasmas (21) in der teilweise evakuierten Atmosphäre (10) oder in einer Probe der teilweise evakuierten Atmosphäre (10);
b. Messen der Intensität von Lichtemissionen aus dem Plasma (21) bei Wellenlängen, die den charakteristischen Emissionswellenlängen jeder der Gasspezies in der teilweise evakuierten Atmosphäre (10) entsprechen;
c. Messen des Gesamtdrucks der teilweise evakuierten Atmosphäre (10); und
d. Berechnen der tatsächlichen Konzentrationen oder Partialdrücke der Zielgasspezies unter Verwendung einer Gleichung der Form:

$$P_t = p_1 + p_2 + p_3 \propto \frac{E_1}{E_1 + E_2 + E_3} + \frac{E_2}{E_1 + E_2 + E_3} + \frac{E_3}{E_1 + E_2 + E_3}$$

wobei:

$P_t$ der gemessene Gesamtdruck der Atmosphäre ist;
$p_1$ der Partialdruck von Spezies 1 ist;
$p_2$ der Partialdruck von Spezies 2 ist;
$p_3$ der Partialdruck von Spezies 3 ist;
$E_1$ die gemessene Emissionsintensität für Spezies 1 bei ihrer charakteristischen Wellenlänge ist;
$E_2$ die gemessene Emissionsintensität für Spezies 2 bei ihrer charakteristischen Wellenlänge ist; und
$E_3$ die gemessene Emissionsintensität für Spezies 3 bei ihrer charakteristischen Wellenlänge ist,

wobei das Verfahren ferner Folgendes umfasst:
Anwenden einer Korrektur auf die gemessene Intensität, die jeder oder der Zielgasspezies entspricht, um eine korrigierte Intensität für jede oder diese Spezies zu erhalten, wobei die korrigierte Intensität proportional zu der tatsächlichen Konzentration jeder oder der Zielgasspezies in der teilweise evakuierten Atmosphäre (10) ist, wobei:

die Korrektur für jede Gasspezies eine separate Funktion der gemessenen Intensitäten für alle Spezies in der teilweise evakuierten Atmosphäre (10) ist; bzw.
die Korrektur eine Funktion der gemessenen Intensitäten aller Spezies in der teilweise evakuierten Atmosphäre (10) ist.

2. Verfahren nach Anspruch 1, wobei die Funktion oder Funktionen die Form linearer Gleichungen vom Koeffiziententyp annimmt/annehmen, wobei die korrigierte Intensität für eine gegebene Spezies die gemessene Konzentration für diese Spezies plus ein Koeffizient multipliziert mit dem Produkt der gemessenen Konzentrationen der anderen Spezies ist.

3. Verfahren nach Anspruch 2, wobei die Funktion Folgendes umfasst:

eine lineare Funktion vom Koeffiziententyp der allgemeinen Form: $Gn_c = Gn + k_{n1}G1 + k_{n2}G2 + \cdots + k_{n(n-1)}G(n-1)$, wobei $Gn_c$ der korrigierte Intensitätswert für das Gas n ist, wobei $k_{nx}$ der Koeffizient ist, der die Gase n und x in Beziehung setzt, und wobei Gx der gemessene Intensitätswert für Gas x ist; oder
eine lineare Funktion vom Koeffiziententyp der allgemeinen Form, die in der allgemeinen Form ausgedrückt werden kann:

$$\begin{bmatrix} G1_c \\ G2_c \\ \vdots \\ Gn_c \end{bmatrix} = \begin{bmatrix} 1 & k_{12}G1 & \cdots & k_{1n}G1 \\ k_{21}G2 & 1 & \cdots & k_{2n}G2 \\ \vdots & \vdots & \ddots & \vdots \\ k_{n1}Gn & k_{n2}Gn & \ldots & 1 \end{bmatrix} \begin{bmatrix} G1 \\ G2 \\ \vdots \\ Gn \end{bmatrix}$$

wobei $Gn_c$ der korrigierte Intensitätswert für jedes Gas n ist, wobei $k_{nx}$ die Koeffizienten sind, die Gase n und x in Beziehung setzen, und wobei Gx der gemessene Intensitätswert für Gas x ist.

4. Verfahren nach Anspruch 3, wobei die Koeffizienten $k_{nn}$ bestimmt werden, indem ein Kalibrierungsverfahren verwendet wird, bei dem ein Gas in die Umgebung eingeführt wird und die Änderung des Messwerts der anderen Gase des Systems aufgezeichnet wird, wobei die Korrekturkoeffizienten bestimmt werden durch:

a. Messen der relativen Intensitäten der Peaks des Plasmaemissionsspektrums für eine Reihe von Prozessgasen bei Anfangskonzentrationen;
b. Anpassen der Konzentration jeder einzelnen der Gasspezies nacheinander, während die Konzentrationen der anderen Gasspezies auf den genannten Ausgangskonzentrationen gehalten werden;
c. für jede Permutation, Messen der Änderungen der gemessenen relativen Intensitäten der Peaks des Plasmaemissionsspektrums; und
d. Bestimmen der Koeffizienten durch Lösen einer Reihe von simultanen Gleichungen.

**5.** Verfahren nach Anspruch 4 für ein binäres Gassystem, wobei die simultanen Gleichungen wie folgt lauten:

$$k_{21} = \frac{G2_c - G2}{G2 G1} \quad -(1)$$

und

$$k_{21} = \frac{G1_c - G1}{G1 G2} \quad -(2)$$

**6.** Verfahren nach Anspruch 4 für ein Gassystem mit $n$ Gasen, wobei die simultanen Gleichungen wie folgt lauten:

$$\begin{bmatrix} k_{12} \\ k_{13} \\ \vdots \\ k_{1n} \end{bmatrix} = \begin{bmatrix} 1 & \frac{G3_1}{G2_1} & \cdots & \frac{Gn_1}{G2_1} \\ \frac{G2_2}{G3_2} & 1 & \cdots & \frac{G3_2}{Gn_2} \\ \vdots & \vdots & \ddots & \vdots \\ \frac{G2_{n-1}}{Gn_{n-1}} & \frac{G3_{n-1}}{Gn_{n-1}} & \cdots & 1 \end{bmatrix}^{-1} \begin{bmatrix} \frac{G1_{c1}}{G1_1 G2_1} - \frac{1}{G2_1} \\ \frac{G1_{c2}}{G1_2 G3_2} - \frac{1}{G3_2} \\ \frac{G1_{cn-1}}{G1_{n-1} Gn_{n-1}} - \frac{1}{Gn_{1n-1}} \end{bmatrix}$$

**7.** Verfahren nach Anspruch 4, 5 oder 6, ferner umfassend den Schritt des Einbeziehens eines Kalibrierungskoeffizienten, um die Tatsache zu kompensieren, dass verschiedene Atome oder Moleküle bei gleichem Partialdruck nicht mit gleicher Intensität Licht emittieren, wobei der Kalibrierungskoeffizient, $K_r$, auf die einzelnen Emissionsmesswerte angewendet wird, um das Verhältnis der Lichtemission zu dem des Verhältnisses der Partialdrücke, $Gr$, gemäß der folgenden Formel umzuwandeln: $Gr_i = \frac{K_{ri} E_i}{\sum_n^{i=1} K_{ri} E_i}$

**8.** Verfahren nach Anspruch 7, wobei der Partialdruck eines Zielgases, $G_p$, durch Multiplizieren der einzelnen Gasverhältnisse mit dem Gesamtdruck, $P_t$, erhalten werden, wobei $G_{pi} = Gr_i P_t$

**9.** Verfahren nach einem der vorstehenden Ansprüche, wobei das Verhältnis jeder Gasemission zu der Gesamtemission, $Er_i$, gegeben ist durch die Gleichung: $Er_i = \frac{E_i}{\sum_n^{i=1} E_i}$

**10.** Verfahren nach einem der vorstehenden Ansprüche, ferner umfassend den Schritt des Korrigierens des Gesamtdrucks durch Verwenden eines Gaskorrekturfaktors für jede Zielgasspezies und durch Multiplizieren des gemessenen Gesamtdrucks mit einem gewichteten Mittelwert der Gaskorrekturfaktoren für jede Zielgasspezies, wobei der gewichtete Mittelwert durch die Formel ausgedrückt wird: $P_{tc} = P_t(Gr_1 k_{p1} + Gr_2 k_{p2} \ldots Gr_n k_{pn})$.

**11.** Verfahren nach einem der vorstehenden Ansprüche, wobei der Gesamtdruck durch Verwenden eines sekundären Druckmessgeräts (17), bei dem es sich um eines oder mehrere aus der Gruppe umfassend ein Kapazitätsmanometer, ein Penning-Manometer und ein Pirani-Manometer handelt - oder durch Verwenden der Spannungs- und/oder Strommessungen des Plasmagenerators des Sensors erhalten wird.

**12.** Verfahren nach einem der vorstehenden Ansprüche, ferner umfassend den Schritt des Umwandelns der korrigierten Intensitätswerte für jede Gasspezies in jeweilige Partialdrücke für jede Gasspezies.

**13.** Verfahren nach Anspruch 12, wobei der Schritt des Umwandelns der korrigierten Intensitätswerte für jede Gasspezies in jeweilige Partialdrücke für jede Gasspezies das Multiplizieren jedes korrigierten Intensitätswertes mit einem Umwandlungskoeffizienten für jedes Gas umfasst, wobei der Umwandlungskoeffizient jeden korrigierten Intensitätswert mit einem entsprechenden Partialdruckwert in Beziehung setzt.

**14.** Verfahren nach Anspruch 12 oder Anspruch 13, wobei der Schritt des Umwandelns der korrigierten Intensitätswerte für jede Gasspezies in jeweilige Partialdrücke für jede Gasspezies Folgendes umfasst: Messen des Gesamtdrucks der teilweise evakuierten Atmosphäre (10) und anteiliges Dividieren des Gesamtdrucks der teilweise evakuierten Atmosphäre (10) gemäß jedem korrigierten Intensitätswert, um einen Partialdruckwert für jedes Gas als Bruchteil des Gesamtdrucks zu erhalten.

15. Vorrichtung (100) zum Ausführen des Verfahrens nach einem der vorstehenden Ansprüche, die Vorrichtung umfassend:

eine Prüfkammer (16), die in Fluidverbindung mit der zu analysierenden teilweise evakuierten Atmosphäre (10) steht, eine Plasmaquelle (18), die dazu ausgelegt ist, ein Plasma (21) in der Prüfkammer (16) zu erzeugen; einen Lichtdetektor, wie ein Spektrometer (20), der angeordnet ist, um Lichtemissionen aus dem Plasma (21) zu erfassen; und einen Prozessor (56), wobei der Prozessor (56) dazu ausgelegt ist, im Betrieb: ein Spektrum der Lichtintensität in Abhängigkeit von der Wellenlänge zu erhalten und die Intensität der Lichtemissionen aus dem Plasma (21) bei Wellenlängen zu bestimmen, die den charakteristischen Emissionswellenlängen jeder der Gasspezies in der teilweise evakuierten Atmosphäre (10) entsprechen, die Partialdrücke der Zielgasspezies zu berechnen und eine Korrektur auf die gemessene Intensität anzuwenden, die jeder oder der Zielgasspezies entspricht, um eine korrigierte Intensität für jede oder diese Spezies zu erhalten, wobei die korrigierte Intensität proportional zu der tatsächlichen Konzentration jeder oder der Zielgasspezies in der teilweise evakuierten Atmosphäre (10) ist, wobei die Korrektur für jede Gasspezies eine separate Funktion der gemessenen Intensitäten für alle Spezies in der teilweise evakuierten Atmosphäre (10) ist; bzw. die Korrektur eine Funktion der gemessenen Intensitäten aller Spezies in der teilweise evakuierten Atmosphäre (10) ist, wobei die Vorrichtung ferner Folgendes umfasst:

ein Gesamtdruckmessgerät (17), bei dem es sich um eines oder mehrere aus der Gruppe umfassend ein Kapazitätsmanometer, ein Penning-Messgerät und ein Pirani-Messgerät handelt, das so konfiguriert ist, dass es den Gesamtdruck in der Prüfkammer (16) misst; und
eine Leitung (14), die die Prüfkammer (16) und die zu analysierende teilweise evakuierte Atmosphäre (10) miteinander verbindet; eine einstellbare begrenzte Öffnung, wie ein Nadelventil (50), wobei die einstellbare begrenzte Öffnung der Leitung (14) zugeordnet ist und es im Gebrauch ermöglicht, eine Druckdifferenz zwischen der zu analysierenden teilweise evakuierten Atmosphäre (10) und einer Atmosphäre innerhalb der Prüfkammer (16) aufrechtzuerhalten; und eine Vakuumpumpe (52) zum Evakuieren der Prüfkammer (16).

## Revendications

1. Procédé de mesure de la concentration ou pression partielle réelle d'une espèce gazeuse cible dans une atmosphère partiellement évacuée (10) comprenant une pluralité d'espèces gazeuses différentes, telles que des espèces 1 à 3, le procédé comprenant les étapes consistant à :

a. générer un plasma (21) dans l'atmosphère partiellement évacuée (10) ou dans un échantillon de l'atmosphère partiellement évacuée (10) ;
b. mesurer l'intensité d'émissions de lumière à partir du plasma (21) à des longueurs d'onde qui correspondent à des longueurs d'onde d'émission caractéristiques de chacune des espèces gazeuses dans l'atmosphère partiellement évacuée (10) ;
c. mesurer la pression totale de l'atmosphère partiellement évacuée (10) ; et
d. calculer les concentrations ou pressions partielles réelles des espèces gazeuses cibles à l'aide d'une équation de cette forme :

$$P_t = p_1 + p_2 + p_3 \propto \frac{E_1}{E_1 + E_2 + E_3} + \frac{E_2}{E_1 + E_2 + E_3} + \frac{E_3}{E_1 + E_2 + E_3}$$

où :

$P_t$ est la pression mesurée totale de l'atmosphère ;
$p_1$ est la pression partielle de l'espèce 1 ;
$p_2$ est la pression partielle de l'espèce 2 ;
$p_3$ est la pression partielle de l'espèce 3 ;
$E_1$ est l'intensité d'émission mesurée pour l'espèce 1, à sa longueur d'onde caractéristique ;
$E_2$ est l'intensité d'émission mesurée pour l'espèce 2, à sa longueur d'onde caractéristique ; et
$E_3$ est l'intensité d'émission mesurée pour l'espèce 3, à sa longueur d'onde caractéristique,

le procédé comprenant en outre :

l'application d'une correction à l'intensité mesurée correspondant à chaque espèce gazeuse cible ou à l'espèce gazeuse cible pour obtenir une intensité corrigée pour chaque espèce ou cette espèce, l'intensité corrigée étant proportionnelle à la concentration réelle de chaque espèce gazeuse cible ou de l'espèce gazeuse cible dans l'atmosphère partiellement évacuée (10), dans lequel :

la correction pour chaque espèce gazeuse est une fonction séparée des intensités mesurées pour l'ensemble des espèces dans l'atmosphère partiellement évacuée (10) ; ou
la correction est une fonction des intensités mesurées pour l'ensemble des espèces dans l'atmosphère partiellement évacuée (10), respectivement.

2. Procédé selon la revendication 1, dans lequel la fonction ou les fonctions prend ou prennent la forme d'équations de type à coefficient linéaire où l'intensité corrigée pour une espèce donnée est la concentration mesurée pour cette espèce, plus un coefficient multiplié par le produit des concentrations mesurées des autres espèces.

3. Procédé selon la revendication 2, dans lequel la fonction comprend :

une fonction de type à coefficient linéaire de la forme générale : $Gn_c = Gn + k_{n1}G1 + k_{n2}G2 + \cdots + k_{n(n-1)}G(n-1)$, où $Gn_c$ est la valeur d'intensité corrigée pour un gaz n, où $k_{nx}$ est le coefficient mettant en relation les gaz n et x, et où Gx est la valeur d'intensité mesurée pour un gaz x ; ou
une fonction de type à coefficient linéaire de la forme générale, qui peut être exprimée sous la forme générale :

$$\begin{bmatrix} G1_c \\ G2_c \\ \vdots \\ Gn_c \end{bmatrix} = \begin{bmatrix} 1 & k_{12}G1 & \cdots & k_{1n}G1 \\ k_{21}G2 & 1 & \cdots & k_{2n}G2 \\ \vdots & \vdots & \ddots & \vdots \\ k_{n1}Gn & k_{n2}Gn & \dots & 1 \end{bmatrix} \begin{bmatrix} G1 \\ G2 \\ \vdots \\ Gn \end{bmatrix}$$

où $Gn_c$ est la valeur d'intensité corrigée pour chaque gaz n, où $k_{nx}$ sont les coefficients mettant en relation les gaz n et x, et où Gx est la valeur d'intensité mesurée pour le gaz x.

4. Procédé selon la revendication 3, dans lequel les coefficients $k_{nn}$ sont déterminés à l'aide d'une procédure d'étalonnage dans laquelle un gaz est introduit dans l'environnement et le changement de lecture des autres gaz de systèmes est enregistré dans lequel des coefficients de correction sont déterminés par :

a. la mesure des intensités relatives des pics du spectre d'émission de plasma pour un ensemble de gaz de traitement à des concentrations initiales ;
b. l'ajustement de la concentration de chacune des espèces gazeuses tour à tour, tout en maintenant les concentrations des autres espèces gazeuses auxdites concentrations initiales ;
c. pour chaque permutation, la mesure des changements des intensités relatives mesurées des pics du spectre d'émission plasma ; et
d. la détermination des coefficients par résolution d'un ensemble d'équations simultanées.

5. Procédé selon la revendication 4, pour un système gazeux binaire, dans lequel les équations simultanées sont :

$$k_{21} = \frac{G2_c - G2}{G2G1} \quad -(1)$$

et

$$k_{21} = \frac{G1_c - G1}{G1G2} \quad -(2)$$

6. Procédé selon la revendication 4, pour un système gazeux comprenant n gaz, dans lequel les équations simultanées sont :

$$\begin{bmatrix} k_{12} \\ k_{13} \\ \vdots \\ k_{1n} \end{bmatrix} = \begin{bmatrix} 1 & \dfrac{G3_1}{G2_1} & \cdots & \dfrac{Gn_1}{G2_1} \\ \dfrac{G2_2}{G3_2} & 1 & \cdots & \dfrac{G3_2}{Gn_2} \\ \vdots & \vdots & \ddots & \vdots \\ \dfrac{G2_{n-1}}{Gn_{n-1}} & \dfrac{G3_{n-1}}{Gn_{n-1}} & \cdots & 1 \end{bmatrix}^{-1} \begin{bmatrix} \dfrac{G1_{c1}}{G1_1 G2_1} - \dfrac{1}{G2_1} \\ \dfrac{G1_{c2}}{G1_2 G3_2} - \dfrac{1}{G3_2} \\ \dfrac{G1_{cn-1}}{G1_{n-1} Gn_{n-1}} - \dfrac{1}{Gn_{1n-1}} \end{bmatrix}$$

7.   Procédé selon la revendication 4, 5 ou 6, comprenant en outre l'étape consistant à incorporer un coefficient d'étalonnage pour compenser le fait que différents atomes ou molécules n'émettent pas de la lumière d'égale intensité lorsqu'ils sont présents à la même pression partielle, le coefficient d'étalonnage, $K_r$, étant appliqué aux lectures d'émission individuelles afin de convertir le rapport d'émission de lumière à celui du rapport de pressions partielles, $Gr$, selon la formule : $Gr_i = \dfrac{K_{ri} E_i}{\sum_n^{i=1} K_{ri} E_i}$

8.   Procédé selon la revendication 7, dans lequel la pression partielle d'un gaz cible, $G_p$ est obtenue par multiplication des rapports de gaz individuels par la pression totale, $P_t$, où $G_{pi} = Gr_i P_t$.

9.   Procédé selon l'une quelconque des revendications précédentes, dans lequel le rapport entre l'émission de chaque gaz et l'émission totale, $Er_i$, est donné par l'équation : $Er_i = \dfrac{E_i}{\sum_n^{i=1} E_i}$

10.   Procédé selon l'une quelconque des revendications précédentes, comprenant en outre l'étape consistant à corriger la pression totale à l'aide d'un facteur de correction de gaz pour chaque espèce gazeuse cible, et par multiplication de la pression totale mesurée par une moyenne pondérée des facteurs de correction de gaz pour chaque espèce cible, la moyenne pondérée étant exprimée par la formule : $P_{tc} = P_t(Gr_1 k_{p1} + Gr_2 k_{p2} \dots Gr_n k_{pn})$.

11.   Procédé selon l'une quelconque des revendications précédentes, dans lequel la pression totale est obtenue à l'aide d'une jauge de pression secondaire (17) qui est un ou plusieurs éléments quelconques du groupe comprenant : un manomètre capacitif ; une jauge de Penning ; et une jauge de Pirani - ou à l'aide des mesures de tension et/ou de courant du générateur de plasma du capteur.

12.   Procédé selon l'une quelconque des revendications précédentes, comprenant en outre l'étape consistant à convertir les valeurs d'intensité corrigées pour chaque espèce gazeuse en pressions partielles respectives pour chaque espèce gazeuse.

13.   Procédé selon la revendication 12, dans lequel l'étape consistant à convertir les valeurs d'intensité corrigées pour chaque espèce gazeuse en pressions partielles respectives pour chaque espèce gazeuse comprend la multiplication de chaque valeur d'intensité corrigée par un coefficient de conversion pour chaque gaz, le coefficient de conversion mettant en relation chaque valeur d'intensité corrigée avec une valeur de pression partielle correspondante.

14.   Procédé selon la revendication 12 ou la revendication 13, dans lequel l'étape consistant à convertir les valeurs d'intensité corrigées pour chaque espèce gazeuse en pressions partielles respectives pour chaque espèce gazeuse comprend : la mesure de la pression totale de l'atmosphère partiellement évacuée (10) et la division de la pression totale de l'atmosphère partiellement évacuée (10) au pro rata conformément à chaque valeur d'intensité corrigée afin d'obtenir une valeur de pression partielle pour chaque gaz en tant que fraction de la pression globale.

15.   Appareil (100) destiné à effectuer le procédé de l'une quelconque des revendications précédentes, l'appareil comprenant :
une chambre de test (16) en communication fluidique avec l'atmosphère partiellement évacuée (10) à analyser, une source de plasma (18) adaptée pour produire un plasma (21) au sein de la chambre de test (16) ; un détecteur de lumière, tel qu'un spectromètre (20), agencé pour détecter des émissions de lumière à partir du plasma (21) ; et un processeur (56), le processeur (56) étant adapté, en utilisation, pour : obtenir un spectre d'intensité de lumière en fonction de la longueur d'onde, et déterminer l'intensité des émissions de lumière à partir du plasma (21) à des longueurs d'onde correspondant aux longueurs d'onde d'émission caractéristiques de chacune des espèces gazeuses dans l'atmosphère partiellement évacuée (10), calculer les pressions partielles des espèces gazeuses cibles, et appliquer une correction à l'intensité mesurée correspondant à chaque espèce gazeuse cible ou à l'espèce gazeuse cible afin d'obtenir une intensité corrigée pour chaque espèce ou cette espèce, l'intensité corrigée étant proportionnelle à la concentration réelle de chaque espèce gazeuse cible ou de l'espèce gazeuse cible dans l'atmosphère partiellement évacuée (10), dans lequel la correction pour chaque espèce gazeuse est une fonction séparée des intensités mesurées pour l'ensemble des espèces dans l'atmosphère partiellement évacuée (10) ; ou la correction est une fonction des intensités mesurées de l'ensemble des espèces dans l'atmosphère partiellement évacuée (10), respectivement, l'appareil comprenant en outre :

une jauge de pression totale (17), qui est un ou plusieurs éléments quelconques du groupe comprenant: un manomètre capacitif; une jauge de Penning; et une jauge de Pirani, configurée pour mesurer la pression totale au sein de la chambre de test (16) ; et

un conduit (14) reliant entre elles la chambre de test (16) et l'atmosphère partiellement évacuée (10) à analyser ; un orifice restreint ajustable, tel qu'une vanne aiguille (50), l'orifice restreint ajustable étant associé au conduit (14), et permet, en utilisation, de maintenir un différentiel de pression entre l'atmosphère partiellement évacuée (10) à analyser et une atmosphère au sein de la chambre de test (16) ; et une pompe à vide (52) destinée à évacuer la chambre de test (16).

Figure 1
(PRIOR ART)

Figure 2
(PRIOR ART)

Figure 3

Figure 4

EP 3 997 445 B1

Figure 5

**EP 3 997 445 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2128301 A1